# EUROPEAN PATENT APPLICATION

(11) **EP 2 426 736 A1**
(43) Date of publication of application: **07.03.2012**
(21) Application number: 10769561.1
(22) Date of filing: 11.03.2010
(51) Int. Cl.: H01L 31/068, H01L 31/0224

(54) **BACKSIDE-ELECTRODE TYPE SOLAR BATTERY AND MANUFACTURING METHOD THEREOF**

(30) Priority: 30.04.2009 JP 2009110667
(71) Applicant: Sharp Kabushiki Kaisha, Osaka-shi, Osaka 545-8522 (JP)
(72) Inventor: FUNAKOSHI, Yasushi, Osaka 545-8522 (JP)
(74) Representative: Hoffmann, Jörg Peter
(86) International application number: PCT/JP2010/054126
(87) International publication number: WO 2010/125861

(57) **Abstract**

The present invention aims to provide a back electrode-type solar cell (20) having improved conversion efficiency and reliability, and a method of manufacturing the back electrode-type solar cell (20) having a reduced number of steps of forming an electrode and using a conductive paste. The back electrode-type solar cell (20) of the present invention includes on one surface of a semiconductor substrate (1) of a first conductivity type, a first doped region (6) identical in conductivity type to the first conductivity type and a second doped region (5) of a second conductivity type different from the first conductivity type, and a first electrode (12) formed on the first doped region (6) and a second electrode (11) formed on the second doped region (5). Each of the first electrode (12) and the second electrode (11) is a fired electrode, and at least the first electrode (12) of the first electrode (12) and the second electrode (11) includes a conductive coating layer (14) on a surface thereof.

## Description

### TECHNICAL FIELD

The present invention relates to a back electrode-type solar cell and a method of manufacturing the same.

### BACKGROUND ART

In recent years, particularly from the standpoint of global environmental protection, there has been a rapidly growing expectation that solar cells for converting sunlight energy into electrical energy will serve as a next-generation energy source. Solar cells are made using compound semiconductors, organic materials, or the like.
In a currently mainstream solar cell, electrodes are each formed on a light-receiving surface of a single-crystal or polycrystalline silicon substrate and on a back surface lying opposite thereto. In this solar cell, a pn junction is formed by diffusing an impurity of the conductivity type of the silicon substrate and an impurity of an opposite conductivity type. It has also been contemplated to achieve higher output owing to a back surface field effect generated by diffusing on the back surface of the silicon substrate, the impurity identical in conductivity type to the silicon substrate in high concentration.

When an electrode is formed on the light-receiving surface as stated above, shadow loss due to the electrode becomes a problem. In order to solve this problem, back surface contact-type solar cells (hereinafter referred to as back electrode-type solar cells) have been developed. In a back electrode-type solar cell, a pn junction is formed on the back surface of a silicon substrate, without forming an electrode on the light-receiving surface of the silicon substrate.

### CITATION LIST

### PATENT LITERATURE

PTL 1 United States Patent No. 7455787
PTL 2 Japanese Patent Laying-Open No. 2006-041105
PTL 3 Japanese Patent Laying-Open No. 2006-332273

### SUMMARY OF INVENTION

### TECHNICAL PROBLEM

In the method of forming an electrode disclosed in United States Patent No. 7455787 (hereinafter denoted as "PTL 1"), n-type and p-type electrodes are patterned using an expensive resist, and complicated etching steps are performed. Further, for example, Japanese Patent Laying-Open No. 2006-041105 (hereinafter denoted as "PTL 2") contemplates a method of forming an electrode (fired electrode) in a simplified manner by directly pattern-printing a conductive paste containing metal powders of, for example, silver, followed by firing.

In a heretofore generally used fired electrode containing silver as a main component, solder is used as a connecting material, and therefore, silver-tin alloy is partially formed. It is believed that this alloy portion tends to cause deterioration in characteristics after long-term use. Moreover, in a back electrode-type solar cell, because of its structure, an n-type electrode and a p-type electrode are opposed to each other at a pitch narrower than that in a solar cell having a conventional structure, and thus, the risk of migration needs to be taken into consideration. In particular, there is also a concern that silver contained in the fired electrode tends to cause migration.

It is also possible to improve F. F. (fill factor) by lowering the series resistance of the electrodes, thus achieving improved cell characteristics. On the other hand, when an electrode paste containing a glass frit is fired, there is a possibility that fire-through of a passivation film may occur. Such fire-through can be a cause of shorting. Therefore, it has been difficult to design an electrode width to extend beyond a diffusion region, inevitably resulting in a narrow electrode width.

The present invention was made in view of the above-described current situations. An object of the present invention is to provide a back electrode-type solar cell having increased conversion efficiency and reliability. Another object of the present invention is to provide a method of manufacturing a back electrode-type solar cell having a reduced number of steps of forming an electrode and using a conductive paste.

### SOLUTION TO PROBLEM

In summary, a back electrode-type solar cell of the present invention includes: on one surface of a semiconductor substrate of a first conductivity type, a first doped region identical in conductivity type to the first conductivity type, and a second doped region of a second conductivity type different in conductivity type from the first conductivity type; and a first electrode formed on the first doped region, and a second electrode formed on the second doped region. Each of the first electrode and the second electrode is a fired electrode, and at least the first electrode of the first electrode and the second electrode includes a conductive coating layer on a surface thereof.

Preferably, the conductive coating layer is composed of nickel, palladium, tin, copper, silver, gold, or aluminum. Further, in one embodiment of the back electrode-type solar cell of the present invention, the conductive coating layer may be provided on a surface of each of the first electrode and the second electrode.

A method of manufacturing a back electrode-type solar cell of the present invention is a method of manufacturing a back electrode-type solar cell including on one surface of a semiconductor substrate of a first conductivity type, a first doped region identical in conductivity type to the first conductivity type and a second doped region of a second conductivity type different in conductivity type from the first conductivity type, and a first electrode formed on the first doped region and a second electrode formed on the second doped region. The method of manufacturing the back electrode-type solar cell includes the steps of forming the first electrode and the second electrode by firing a conductive paste, and forming a conductive coating layer on a surface of at least the first electrode of the first electrode and the second electrode formed by firing. The step of forming a conductive coating layer includes selectively forming the conductive coating layer on a surface of the first electrode or the second electrode formed by firing.

Preferably, the step of forming a conductive coating layer is performed by electroplating, and the conductive coating layer made by plating is selectively formed on the first electrode or the second electrode formed by firing, by using a roller capable of conducting electricity, while transferring the semiconductor substrate that is being immersed in a plating solution. In another embodiment, the step of forming a conductive coating layer may be performed by electroless plating, and the conductive coating layer made by plating is selectively formed on the first electrode or the second electrode formed by firing, by using, as an autocatalyst, a metal component of the first electrode or the second electrode formed by firing. In still another embodiment of the manufacturing method of the present invention, the step of forming a conductive coating layer includes selectively forming the conductive coating layer made by plating on either one of the first electrode and the second electrode formed by firing, by using electromotive force of a pn junction formed in the semiconductor substrate.

### ADVANTAGEOUS EFFECTS OF INVENTION

According to the present invention, a back electrode-type solar cell having increased reliability and conversion efficiency and a method of manufacturing such a back electrode-type solar cell can be provided by providing a conductive coating layer on a fired electrode formed on a back surface of a solar cell.

### BRIEF DESCRIPTION OF DRAWINGS

Fig. 1 is a schematic cross-sectional view showing a back electrode of a back electrode-type solar cell of the present invention.
Fig. 2 shows schematic cross-sectional views showing one preferred example of steps of manufacturing the back electrode-type solar cell of the present invention.
Fig. 3(a) is a cross-sectional view illustrating one preferred example of steps of manufacturing a conductive coating layer by electroplating, and Fig. 3(b) is a plan view viewed from a top surface of Fig. 3(a).
Fig. 4 is a schematic cross-sectional view showing one preferred example of steps of manufacturing a conductive coating layer by electroless plating.
Fig. 5 is a schematic diagram for use in explaining the formation of a through-hole in a back electrode-type solar cell.
Fig. 6 is a schematic cross-sectional view showing one preferred example of steps of manufacturing a conductive coating layer by electroless plating using the electromotive force of a pn junction.

### DESCRIPTION OF EMBODIMENTS

Embodiments of the present invention will be described hereinafter. In the drawings of the present application, the same or corresponding elements have the same reference characters allotted.

### <First Embodiment>

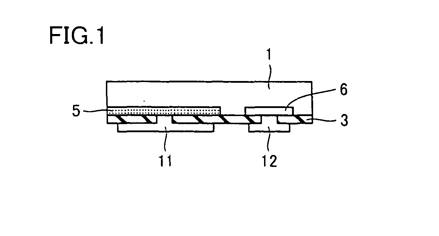

As shown in Fig. 1, a back electrode-type solar cell of the present invention includes on one surface of a semiconductor substrate 1 of a first conductivity type, a first doped region 6 that is identical in conductivity type to the first conductivity type, and a second doped region 5 of a second conductivity type that is different in conductivity type from the first conductivity type. The back electrode-type solar cell has a first electrode 12 formed on first doped region 6, and a second electrode 11 formed on second doped region 5. When the first conductivity type is a p-type, the second conductivity type is an n-type, and when the first conductivity type is an n type, the second conductivity type is a p-type. First doped region 6 is a region of the first conductivity type, having an impurity concentration higher than that in semiconductor substrate 1, and second doped region 5 is a region having the second conductivity type different from the first conductivity type.

When the first conductivity type is a p-type, a p-type dopant, for example, boron or aluminum, can be used as a dopant of the first conductivity type. When the first conductivity type is an n-type, an n-type dopant, for example, phosphorus or arsenic, can be used as a dopant of the first conductivity type.

Moreover, when the second conductivity type is an n-type, an n-type dopant, for example, phosphorus or arsenic, can be used as a dopant of the second conductivity type. When the second conductivity type is a p-type, a p-type dopant, for example, boron or aluminum, can be used as a dopant of the second conductivity type.

As shown in Fig. 1, the back electrode-type solar cell having the above-described structure includes a passivation film 3 on surfaces of first doped region 6 and second doped region 5. Passivation film 3 has the effect of passivating (passivation; de-activating grain-boundaries) a wafer surface. Although passivation film 3 is not particularly limited as long as it is a film having properties that serve as a barrier against impurity diffusion, a film made of silicon oxide, amorphous silicon, silicon nitride, titanium oxide, or aluminum oxide can be used as passivation film 3. Preferably, the characteristics of passivation film 3 do not deteriorate even when firing during the formation of an electrode is conducted under high-temperature conditions. Although not illustrated herein, a surface opposite to the surface on which the doped regions are formed (light-receiving surface) has a textured structure, and an anti-reflection coating is preferably formed on a surface thereof.

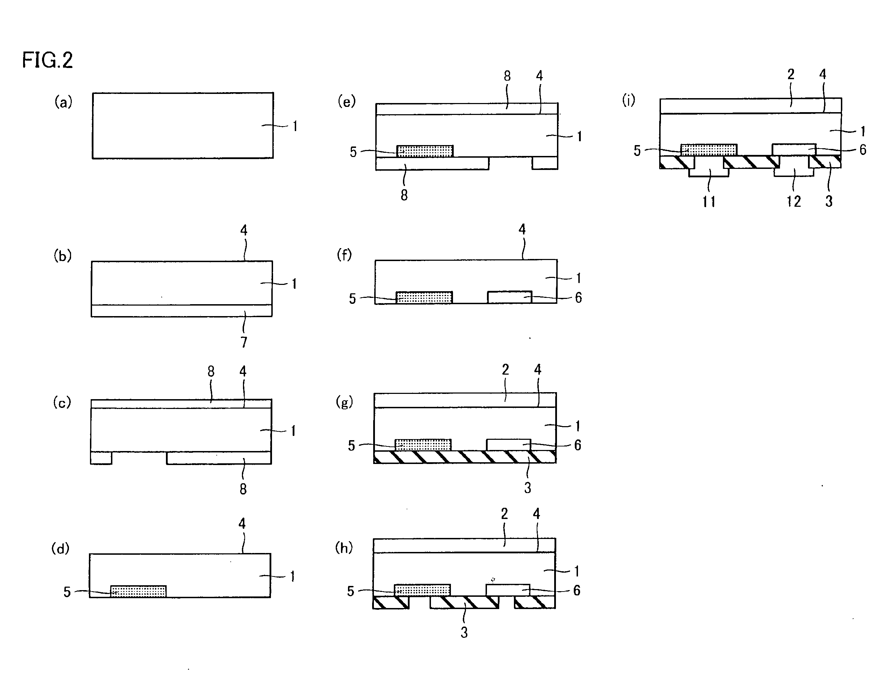

Referring to schematic cross-sectional views in Figs. 2(a) to 2(i), one example of a method of manufacturing the back electrode of the back electrode-type solar cell shown in Fig. 1 will be described hereinafter.

Initially, as shown in Fig. 2(a), semiconductor substrate 1 is prepared. Although semiconductor substrate 1 used herein is not particularly limited as long as it is a substrate made of a semiconductor, for example, a silicon substrate obtained by slicing a silicon ingot can be used as semiconductor substrate 1. The conductivity type of semiconductor substrate 1 is not particularly limited, either, and semiconductor substrate 1 may have n-type or p-type conductivity, or may have neither n-type nor p-type conductivity. In the present embodiment, a case where n-type semiconductor substrate 1 is used will be described.

When a silicon substrate is used as semiconductor substrate 1, for example, a silicon substrate from which slice damage caused by slicing a silicon ingot has been eliminated can be used as semiconductor substrate 1. Such slice damage is preferably eliminated by, for example, etching a surface of the silicon substrate after slicing, using a mixed acid of a hydrogen fluoride aqueous solution and nitric acid, an alkaline aqueous solution of sodium hydroxide or the like, etc.

Although the size and shape of semiconductor substrate I are not particularly limited, from a practical point of view, semiconductor substrate 1 may have a thickness not less than 100 µm and not more than 300 µm and have a rectangular surface having one side not less than 100 mm and not more than 200 mm.

A textured structure 4 may be formed on the light-receiving surface of the back electrode-type solar cell of the present invention. In Fig. 2, textured structure 4 is indicated by straight lines for convenience' sake. Any textured structure having a fine concavo-convex structure formed thereon may be used as textured structure 4. Examples of such textured structures include known three-dimensional shapes such as a pyramidal structure in which triangular prisms are formed at intervals, a structure in which an infinite number of holes resembling craters are formed, a structure having semicylindrical projections, and a prismatic structure in which triangular prisms are formed continuously without any intervals.

As shown in Fig. 2(b), such textured structure 4 on the light-receiving surface of semiconductor substrate 1 is formed after masking a back surface of semiconductor substrate 1 by forming a texturing mask 7 made of a silicon oxide film on the back surface by an atmospheric pressure CVD method. Textured structure 4 on the light-receiving surface is formed by, for example, etching semiconductor substrate 1 having texturing mask 7 formed thereon, using an etchant or reactive plasma. One example of the etchant is a solution obtained by adding isopropyl alcohol to an alkaline aqueous solution of sodium hydroxide, potassium hydroxide, or the like. The etchant is heated to, for example, not less than 70°C and not more than 80°C when it is used. After textured structure 4 has thus been formed, texturing mask 7 is removed using, for example, a hydrogen fluoride aqueous solution. Any texturing mask that is insoluble in the etchant and soluble in a removing solution such as a hydrogen fluoride solution can be used as texturing mask 7. Where textured structure 4 is not needed on the light-receiving surface, the step shown in Fig. 2(b) can naturally be omitted.

Next, as shown in Fig. 2(c), a diffusion mask 8 made of a silicon oxide film is formed on each of the light-receiving surface and the back surface of semiconductor substrate 1. An opening is then formed in diffusion mask 8 on the back surface. First, diffusion mask 8 is formed on each of the light-receiving surface and the back surface of semiconductor substrate 1 by the atmospheric pressure CVD method. An etching paste is then applied onto diffusion mask 8 in a desired opening pattern shape, and the applied paste is subsequently subjected to heat treatment. Residue of the etching paste is then cleaned off, thereby providing semiconductor substrate 1 having an opening formed in diffusion mask 8. In the present embodiment, this opening is to be formed in a portion corresponding to the position of a p+ layer described later. An etching paste containing a known etching component for etching the silicon oxide film is used as the etching paste.

After a p-type impurity is diffused into the opening formed as above, diffusion mask 8 is cleaned with, for example, a hydrogen fluoride (HF) aqueous solution, thereby forming second doped region 5, which is a p+ layer, as shown in Fig. 2(d). The p-type impurity is diffused by subjecting the exposed back surface of semiconductor substrate 1 to, for example, vapor phase diffusion using BBr₃ as a raw material. After the diffusion, diffusion mask 8 on the light-receiving surface and the back surface of semiconductor substrate 1, and boron silicate glass (BSG) formed by the diffusion of boron derived from BBr₃, are removed using, for example, a hydrogen fluoride aqueous solution.

Next, as shown in Fig. 2(e), after diffusion mask 8 is formed on the light-receiving surface and the back surface of semiconductor substrate 1, an opening is formed in diffusion mask 8 on the back surface. The opening in diffusion mask 8 is formed in a portion corresponding to the position of an n+ layer described later. The opening can be formed by the same method as that used when forming second doped region 5.

Then, by way of the same step as that of forming second doped region 5, first doped region 6, which is an n+ layer, is formed as shown in Fig. 2(f). That is, after diffusing an n-type impurity into the opening formed as described above, diffusion mask 8 is cleaned off with, for example, a hydrogen fluoride aqueous solution. The n-type impurity is diffused by subjecting the exposed back surface of semiconductor substrate 1 shown in Fig. 2(e) to, for example, vapor phase diffusion using POCl₃ as a raw material. After the diffusion, the above-described diffusion mask 8 on the light-receiving surface and the back surface of semiconductor substrate 1, and phosphorus silicate glass (PSG) formed by the diffusion of phosphorus derived from POCl₃, are removed using, for example, a hydrogen fluoride aqueous solution. This results in first doped region 6 being formed on the back surface of semiconductor substrate 1, as shown in Fig. 2(f).

Then, as shown in Fig. 2(g), an anti-reflection coating 2 made of a silicon nitride film is formed on the light-receiving surface of semiconductor substrate 1, and a passivation film 3 made of a silicon oxide film is formed on the back surface of semiconductor substrate 1. First, passivation film 3 made of a silicon oxide film is formed on the back surface of semiconductor substrate 1 by, for example, thermal oxidation. Anti-reflection coating 2 made of a silicon nitride film is subsequently formed on the light-receiving surface of semiconductor substrate 1 by, for example, a plasma CVD method.

Then, in order to ensure electrical conduction between the back electrode and each of the doped regions of the back electrode-type solar cell, contact holes are formed by partially exposing each of second doped region 5, i.e., the p+ layer, and first doped region 6, i.e., the n+ layer, as shown in Fig. 2(h). The contact holes are formed by partially removing passivation film 3 on the back surface of semiconductor substrate 1 by etching using an etching paste.

Next, as shown in Fig. 2(i), a p-type second electrode 11, which contacts the exposed surface of second doped region 5, i.e., the p+ layer, via a contact hole, is formed. Similarly, an n-type first electrode 12, which contacts the exposed surface of first doped region 6, i.e., the n+ layer, via a contact hole, is formed. In the present invention, each of first electrode 12 and second electrode 11 is formed of a fired electrode. That is, each of first electrode 12 and second electrode 11 is formed by way of a step of applying a conductive paste in a desired pattern, followed by firing. In the present invention, the distance (pitch) between the p-type and n-type electrodes is preferably 0.2 mm to 1 mm.

The conductive paste is not particularly limited as long as it can be used as an electrode of a solar cell. One example of the conductive paste is a conductive paste mainly composed of metal powders of aluminum, silver, copper, nickel, or the like, and containing a glass frit, an organic vehicle, and an organic solvent. For example, a preferred blending ratio in the conductive paste is such that metal powders account for 60 to 80 mass% of the total, the glass frit accounts for 1 to 10 mass% of the total, and organic vehicle accounts for 1 to 15 mass% of the total, with the remainder being the organic solvent. By setting the blending ratio as described above, it is possible to satisfactorily form a conductive coating layer described later. The conductive paste can be applied by printing according to a known method, such as screen printing, an ink-jet method, or the like.

Here, in the above-described step of firing, the paste material mainly composed of the metal powders described above is fired in an oxidizing atmosphere furnace at a temperature of 400°C or more. At this time, the organic vehicle, which is a resin component, is burned, and the metal particles in powdered form undergo solid-phase metal diffusion from contact portions between metal particles to form an integrated metal mass, thus exhibiting conductivity. On the other hand, the frit, which is dispersed in the paste material, remains three-dimensionally distributed therein excluding in the contacts between metal particles, consequently imparting adhesion between a surface of semiconductor substrate 1 and the sintered metal.

The method of manufacturing the fired electrode obtained according to the foregoing steps is simple and achieves high productivity. However, because the metal is exposed at electrode surfaces, it undergoes various reactions such as oxidation by the ambient atmosphere, resulting in lowered cell characteristics. In particular, although generally used fired electrodes containing silver are beneficial in that they have low resistance and can be solder-connected, because of the properties of silver, they tend to undergo oxidation and sulfuration by the ambient atmosphere. Additionally, when these electrodes are solder-connected, silver tends to form a compound with tin, which is a main component of solder, and the silver-tin alloy causes increase in the electrode resistance, possibly resulting in lowered cell characteristics.

Moreover, in a back electrode-type solar cell in which a p-type electrode and an n-type electrode are formed at a narrow pitch, care needs to be taken to avoid migration. Among various metal materials, however, silver is known as a metal that is most likely to cause migration. In the present invention, by providing on a fired electrode a conductive coating layer that exhibits properties different from those of the fired electrode, it is possible to fabricate a fired electrode simply and with high productivity, and also provide a highly reliable fired electrode. The conductive coating layer preferably uses a metal different from the metal used for the fired electrode. The conductive coating layer may contain one or more metals different from that of the fired electrode, and may have a single layer or a layered structure.

Furthermore, it is effective to reduce the electrode resistance, in order to improve the performance of a solar cell. The formation of the conductive coating layer on the fired electrode as described above increases the cross-sectional area of the electrode to lower the electrode resistance, leading also to an expected improvement in cell characteristics.

Such a conductive coating layer is provided to cover a surface of the fired electrode. As a material constituting the conductive coating layer, it is preferred to use, for example, a single layer made of a metal of any of nickel, palladium, tin, copper, silver, gold, aluminum, and the like, or a single layer made of a combination thereof, or a layered structure thereof. Although the thickness of the conductive coating layer is not particularly limited, the coating layer is preferably thick in order to further reduce the electrode resistance. Since the fired electrode has a porous shape, the electrode resistance can be expected to effectively decrease only by depositing the conductive coating layer on voids in the fired electrode to increase contacts.

The conductive coating layer is preferably formed by plating, because plating is excellent in imparting close adhesion of the conductive coating layer to the surface of the fired electrode, and facilitates the manufacturing steps. Examples of plating methods include electroplating, electroless plating, and a plating method utilizing an internal electric field in a solar cell. Electroplating is beneficial in that there is an abundant number of usable metal species, and the thickness can be easily increased. Electroless plating is beneficial in that, since it is unnecessary to conduct electricity to an electrode of a solar cell, a simple apparatus may be used for manufacturing, and high productivity is also achieved. These plating methods enable the surface of the fired electrode to be selectively coated (selectivity is achieved because the conductive coating layer is not formed on portions excluding the electrode). This eliminates the need for such complicated steps as forming a pattern by using a resist, as in conventional formation by plating, thus achieving high productivity.

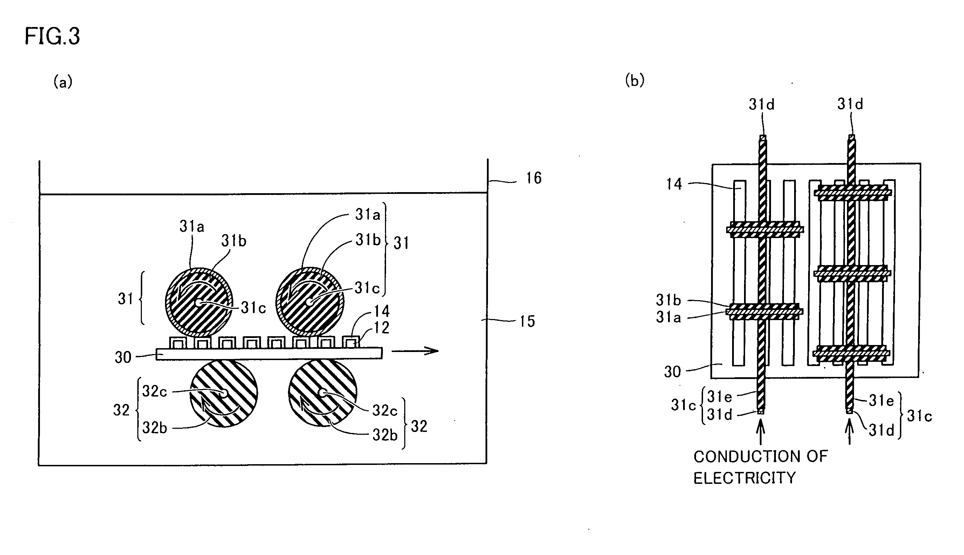

A method of forming the conductive coating layer by electroplating will be described hereinafter. First, a semiconductor substrate having a first electrode and a second electrode thereon is immersed in a solution containing an activating agent.
A generally known activating agent is usable as the activating agent. The semiconductor substrate is preferably immersed in, for example, an aqueous solution containing ammonium fluoride for 1 minute at room temperature. After being treated with the activating agent, the semiconductor substrate is washed with water and then subjected to electroplating by being immersed in a plating solution 15 in a vessel 16, as shown in Fig. 3(a). Fig. 3(a) shows a schematic diagram illustrating exemplary electroplating, and Fig. 3(b) is a plan view showing a portion of Fig. 3(a) viewed from the top. An existing electrolytic copper plating solution containing copper sulfate and sulfuric acid can be used as plating solution 15. Although electroplating can be performed by a generally known method, a solar cell, which is formed using a silicon substrate of 200 µm or less, can be very easily broken. Therefore, rather than holding the semiconductor substrate between clips or similar jigs for allowing electricity to conduct to the electrode of the solar cell, a method of forming a plating layer as shown in Figs. 3(a) and 3(b) is preferred, in which semiconductor substrate 30 is placed in plating solution 15 such that the cell electrode comes into contact with a surface of a roller 31 that can conduct electricity, semiconductor substrate 30 is then transferred in plating solution 15 by rotating roller 31 and a roller 32, and, in this way, electricity is fed to first electrode 12 or second electrode 11 of the solar cell, thereby forming a plating layer. Unlike in the method wherein the semiconductor substrate is held between clips, load is not locally applied with this method, and therefore, this method is highly effective in preventing cracking of the solar cell. Furthermore, by adjusting the position of each roller, it is possible to suppress a distribution of thicknesses of the plating layer. Plating solution 15 used in electroplating is adjusted to a pH of 1 or less and a temperature of 20°C, and 4 µm thick copper was deposited as a result of 5 minute treatment.

As roller 31, a roller can be used that can conduct electricity and is obtained by coating a conductive roller having a roller body 31a and a shaft 31c with insulating films using an insulator 31b and an insulator 31e on portions of the conductive roller that are not contacted with the electrode to be plated. The plating output onto the roller body is suppressed by using roller 31 having these insulating films. On the other hand, roller 32 is provided to support and/or transfer semiconductor substrate 30 and therefore, needs not conduct electricity. A roller whose roller body around a shaft 32c is formed of an insulator 32b can thus be used as roller 32. The size of each of these rollers may be adjusted as required to match the semiconductor substrate.

A conventionally known plating solution containing desired metal ions for forming conductive coating layer 14 can be used as plating solution 15. One example of plating solution 15 is a solution obtained by adding an additive as required to nickel chloride, tin sulfate, gold potassium cyanide, silver potassium cyanide, diamminedichloropalladium salt, or the like.

The present invention can provide a highly reliable solar cell by including conductive coating layer 14 on the surface of a fired electrode, and also allows increase in the cross-sectional area of the electrode, thus achieving satisfactory electrical conduction. Furthermore, according to the manufacturing method of the present invention, the conductive coating layer can be selectively formed on the fired electrode, thus simply achieving a desired function.

### <Second Embodiment>

In connection with the method of manufacturing a back surface contact-type solar cell of the present invention, a method of forming a conductive coating layer using electroless plating as a plating method will be described below. The second embodiment is the same as the first embodiment excluding the plating method, and therefore, the same description will not be repeated.

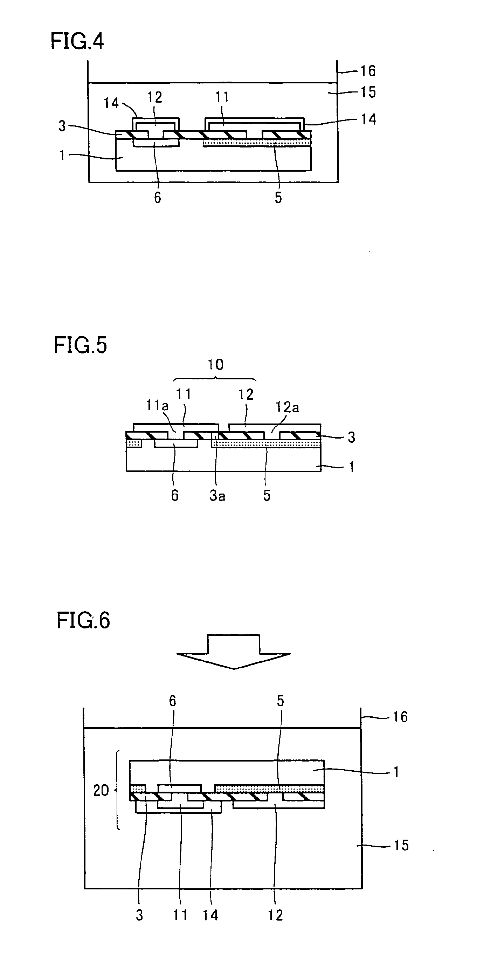

The step of forming each of the fired electrodes is the same as that in the first embodiment. After forming first electrode 12 and second electrode 11, i.e., fired electrodes, on a back surface of semiconductor substrate 1, semiconductor substrate 1 is immersed in plating solution 15 as shown in Fig. 4, thereby allowing conductive coating layer 14 to be formed on desired portions.

First, the semiconductor substrate having the first electrode and the second electrode formed thereon is immersed in an activating agent. An activating agent as exemplified in the first embodiment may be used as an activating agent. After being treated with the activating agent, the semiconductor substrate is washed with water and then subjected to electroless plating by being immersed in the plating solution, as shown in Fig. 4. One example of a usable plating solution is an existing reduction copper plating solution containing copper sulfate, formaldehyde, EDTA, and sodium hydroxide.

In the above-described electroless plating method, the conductive coating layer is selectively provided on a surface of the fired electrode, by using an electrode containing silver as a component as the fired electrode, and using silver as an autocatalyst. This method not only allows the conductive coating layer to be selectively formed on the fired electrode, but also allows treatment with a palladium catalyst, which is generally used in electroless plating, to be omitted. Thus, since the step is omitted and expensive palladium needs not be used, cost reduction can be achieved. As one example of electroless plating, the semiconductor substrate was immersed for 30 minutes in the above-described copper plating solution at a pH adjusted to 12 and a temperature adjusted to 50°C, thereby obtaining a 2 µm thick copper deposit.

In electroless plating, although the thickness of the conductive coating layer cannot be increased as compared to that obtained in electroplating, a device for conducting electricity as used in electroplating is unnecessary, and the conductive coating layer can be selectively formed on the fired electrode only by immersion in a plating solution, thus leading to improved workability.

In the method using a fired electrode as an autocatalyst, because the plating solution needs to be strongly alkaline as described above, the back electrode-type solar cell may be adversely affected. Further, depending on the metal material of the fired electrode, the fired electrode may not serve as an autocatalyst; in this case, however, electroless plating can also be achieved by performing catalytic treatment with palladium or the like prior to plating treatment. The catalytic treatment may be performed by firstly treating the semiconductor substrate with an activating agent, followed by washing with water, as described above, and subsequently by immersing the semiconductor substrate in a catalytic solution. The semiconductor substrate is immersed in, for example, an acidic solution containing palladium chloride used as the catalytic solution, causing palladium ions to be adsorbed on the surface of the fired electrode. Here, although a known catalyst may be used as a catalyst, an ionic catalyst is preferred. When, for example, a palladium-tin colloidal catalyst is used, plating is formed not only on the fired electrode but over the entire surface of the solar cell. Consequently, the conductive coating layer cannot be selectively formed on the surface of the fired electrode. The conductive coating layer can be selectively formed on the surface of the fired electrode by applying the catalyst to the electrode surface, and then by immersing the semiconductor substrate in an existing reduction nickel plating solution containing nickel chloride or ammonium chloride and having a pH of 6.5.

As an alternative to the above-mentioned plating solution, a conventionally known plating solution containing desired metal ions for forming conductive coating layer 14 can be used. One example of such a plating solution is a solution obtained by adding an additive as required to copper chloride, nickel sulfate, or the like.

In the present invention, the conductive coating layer can be selectively formed on the fired electrode according to a very simple method by using electroless plating. Furthermore, a highly reliable back electrode-type solar cell can be provided by providing conductive coating layer 14, which overcomes problems of the fired electrode.

### <Third Embodiment>

In connection with the method of manufacturing a back electrode-type solar cell of the present invention, a method of forming a conductive coating layer by plating utilizing an internal electric field in a solar cell will be described below. The third embodiment is the same as the first embodiment excluding the formation of a conductive coating layer, and therefore, the same description will not be repeated.

The step of forming each fired electrode is the same as that in the first embodiment. Here, in semiconductor substrate 1, in order to increase the junction area to achieve a high current value, for example, in the case of an n-type semiconductor substrate, a diffusion layer is formed to increase second doped region 5, which is a p+ layer. For example, Japanese Patent Laying-Open No. 2006-332273 (hereinafter denoted as "PTL 3") describes that the junction area is preferably 60% or more. Generally, making the first and second electrodes identical in width (cross-sectional area) is effective, in order to reduce resistive loss in the electrodes. However, when the area of one diffusion layer is thus greater, as shown in Fig. 5, a through-hole 3a may be formed in second electrode 11, which is a fired electrode, through passivation film 3b, and second electrode 11 may come into contact with the diffusion layer of a different conductivity type (second doped region 5).

That is, in the manufacturing method of the present invention, a contact hole 11a or a contact hole 12a is provided so as to ensure that a contact between the semiconductor substrate and each of the electrodes can be achieved. The fired electrode contains a glass frit, in order to achieve a contact with semiconductor substrate 1 or ensure adhesion strength. Due to the effects of the glass frit, unintended formation of through-hole 3a through passivation film 3 may occur during the firing of the electrode. Through-hole 3a causes electrical conduction between first electrode 12 and second doped region 5, which can be a cause of shorting. In order to prevent this, first electrode 12 and second electrode 11 may be formed so that they lie within second doped region 5 and first doped region 6, respectively, as shown in Fig. 6. However, when first electrode 12 and second electrode 11 are formed in this way, the width of one of the electrodes is small. In this case, the solar cell characteristics tend to deteriorate because a resistive component is increased due to the narrow electrode width.

According to the present invention, the conductive coating layer is selectively formed on the narrower electrode, so as to allow electrodes wider than respective doped regions to be formed, without penetrating the passivation film, thereby allowing a reduction in the resistive loss and achieving improvement in the solar cell characteristics. Furthermore, a highly reliable back surface contact-type solar cell can be provided by selectively forming the conductive coating layer on the surface of the fired electrode. Fig. 6 is a schematic diagram illustrating a plating method according to the present third embodiment.

A method of thus selectively forming the conductive coating layer is as follows: First, a semiconductor substrate having a first electrode and a second electrode formed thereon is immersed in an activating agent. An activating agent as exemplified in the first embodiment may be used as an activating agent. After being treated with the activating agent, the semiconductor substrate is washed with water and then subjected to plating by being immersed in plating solution 15 in vessel 16, as shown in Fig. 6.
In Fig. 6, back electrode-type solar cell 20 is set horizontally such that the light-receiving surface side is irradiated with light (indicated by the arrow in Fig. 6); however, the plating method is not limited thereto, as long as back electrode-type solar cell 20 is irradiated with light. Upon irradiation of back electrode-type solar cell 20 with light, internal electromotive force is generated, causing metal ions that are present as cations in the plating solution to be deposited on the negative electrode, thus achieving plating. Since the present method utilizes the photoelectromotive force of the back electrode-type solar cell, the growth rate of plating becomes higher as the intensity of the light impinging on the back electrode-type solar cell becomes higher. One example of a usable plating solution is an existing nickel plating solution containing nickel chloride, ammonium chloride, formaldehyde, and potassium hydroxide.

With light equivalent to 1 SUN being directed to back electrode-type solar cell 20, back electrode-type solar cell 20 was immersed for 5 minutes in the above-described nickel plating solution at a pH adjusted to 10 and a temperature adjusted to 25°C, thereby obtaining a 10 µm thick nickel deposit.

By using the manufacturing method of the present third embodiment, it is possible to plate only the n-type electrode in a very simplified manner, as described above. Moreover, by increasing the cross-sectional area and surface area of the electrode, it is possible to achieve high solar cell characteristics and also eliminate the risk of shorting due to the passivation film being penetrated, whereby a highly reliable back electrode-type solar cell is obtained.

While embodiments of the present invention have been described as above, it has been originally contemplated to combine the foregoing embodiments as appropriate, for example, by forming a copper coating layer on a surface of a fired silver electrode for the purpose of suppressing the formation of a silver-tin alloy, and by further forming a tin coating layer on the copper surface in order to prevent deterioration due to the oxidation of copper.

It should be understood that the embodiments disclosed herein are illustrative and non-restrictive in every respect. The scope of the present invention is defined by the terms of the claims, rather than by the foregoing description, and is intended to include any modifications within the scope and meaning equivalent to the terms of the claims.

### REFERENCE SIGNS LIST

1, 30: semiconductor substrate, 2: anti-reflection coating, 3: passivation film, 4: textured structure, 5: second doped region, 6: first doped region, 7: texturing mask, 8: diffusion mask, 11: second electrode, 11a, 12a: contact hole, 12: first electrode, 14: conductive coating layer, 15: plating solution, 16: vessel, 20: back electrode-type solar cell, 31, 32; roller.

## Claims

1. A back electrode-type solar cell (20) comprising:
on one surface of a semiconductor substrate (1) of a first conductivity type,
a first doped region (6) identical in conductivity type to said first conductivity type, and a second doped region (5) of a second conductivity type different from said first conductivity type; and
a first electrode (12) formed on said first doped region (6), and a second electrode (11) formed on said second doped region (5);
each of said first electrode (12) and said second electrode (11) being a fired electrode, and
at least said first electrode (12) of said first electrode (12) and said second electrode (11) including a conductive coating layer (14) on a surface thereof.

2. The back electrode-type solar cell (20) according to claim 1, wherein
said conductive coating layer (14) is composed of nickel, palladium, tin, copper, silver, gold, or aluminum.

3. The back electrode-type solar cell (20) according to claim 1, wherein
the conductive coating layer (14) is provided on a surface of each of said first electrode (12) and said second electrode (11).

4. A method of manufacturing a back electrode-type solar cell (20) including on one surface of a semiconductor substrate (1) of a first conductivity type, a first doped region (6) identical in conductivity type to said first conductivity type and a second doped region (5) of a second conductivity type different from said first conductivity type, and a first electrode (12) formed on said first doped region (6) and a second electrode (11) formed on said second doped region (5), comprising the steps of:
forming the first electrode (12) and the second electrode (11) by firing a conductive paste; and
forming a conductive coating layer (14) on a surface of at least the first electrode (12) of said first electrode (12) and said second electrode (11) formed by firing;
said step of forming a conductive coating layer (14) including selectively forming the conductive coating layer (14) on a surface of said first electrode (12) or said second electrode (11) formed by firing.

5. The method of manufacturing a back electrode-type solar cell (20) according to claim 4, wherein
said step of forming a conductive coating layer (14) is performed by electroplating, and
the conductive coating layer (14) made by plating is selectively formed on said first electrode (12) or said second electrode (11) formed by firing, by using a roller capable of conducting electricity, while transferring said semiconductor substrate (1) that is being immersed in a plating solution (15).

6. The method of manufacturing a back electrode-type solar cell (20) according to claim 4, wherein
said step of forming a conductive coating layer (14) is performed by electroless plating, and
the conductive coating layer (14) made by plating is selectively formed on said first electrode (12) or said second electrode (11) formed by firing, by using, as an autocatalyst, a metal component of said first electrode (12) or said second electrode (11) formed by firing.

7. The method of manufacturing a back electrode-type solar cell (20) according to claim 4, wherein
in said step of forming a conductive coating layer (14), the conductive coating layer (14) made by plating is selectively formed on either one of said first electrode (12) and said second electrode (11) formed by firing, by using electromotive force of a pn junction formed in said semiconductor substrate (1).
